Europäisches Patentamt

European Patent Office

Office européen des brevets

(11) Numéro de publication : **0 115 225 B1**

(12) **FASCICULE DE BREVET EUROPÉEN**

(45) Date de publication du fascicule du brevet : 06.05.87

(51) Int. Cl.⁴ : **H 04 N 3/15, H 01 L 27/14**

(21) Numéro de dépôt : **83402360.8**

(22) Date de dépôt : **06.12.83**

(54) **Procédé d'analyse d'un dispositif photosensible à transfert de ligne et dispositif de mise en œuvre d'un tel procédé.**

(30) Priorité : 21.12.82 FR 8221396
09.09.83 FR 8314403

(43) Date de publication de la demande :
08.08.84 Bulletin 84/32

(45) Mention de la délivrance du brevet :
06.05.87 Bulletin 87/19

(84) Etats contractants désignés :
DE FR GB NL

(56) Documents cités :
EP-A- 0 029 351
EP-A- 0 064 890
EP-A- 0 078 038
ELECTRON DEVICE LETTERS, vol. EDL-1, no. 5, mai 1980, pages 86-89, IEEE, New York; USA. S. TERA-KAWA et al.: "A new organization area image sensor with CCD readout through charge priming transfer"

(73) Titulaire : THOMSON-CSF
173, Boulevard Haussmann
F-75379 Paris Cedex 08 (FR)

(72) Inventeur : Berger, Jean-Luc
THOMSON-CSF SCPI 173, bld Haussmann
F-75379 Paris Cedex 08 (FR)
Inventeur : Brissot, Louis
THOMSON-CSF SCPI 173, bld Haussmann
F-75379 Paris Cedex 08 (FR)
Inventeur : Cazaux, Yvon
THOMSON-CSF SCPI 173, bld Haussmann
F-75379 Paris Cedex 08 (FR)

(74) Mandataire : Ruellan-Lemonnier, Brigitte et al
THOMSON-CSF SCPI 19, avenue de Messine
F-75008 Paris (FR)

**0 115 225**

## Description

La présente invention concerne un procédé d'analyse d'un dispositif photosensible à transfert de ligne. Elle concerne également un dispositif de mise en œuvre d'un tel procédé.

On connaît dans l'art antérieur, notamment par les brevets français n° 2.481.553 et 2.504.334, des dispositifs photosensibles dont l'analyse s'effectue par transfert de ligne. Toutefois ces dispositifs présentent des inconvénients au niveau de l'efficacité du transfert des charges-signal.

La présente invention cherche donc, par rapport aux solutions connues qui seront exposées dans la description détaillée des figures, à améliorer l'efficacité du transfert des charges-signal depuis les colonnes conductrices adressant les points photosensibles jusqu'au registre de lecture. En fait, la présente invention cherche à améliorer l'efficacité du transfert sans dégrader certaines des caractéristiques du dispositif photosensible à transfert de ligne, telles que :

— le bruit ajouté au signal lu ;

— la quantité de charges que doit véhiculer le registre de lecture. En effet, si cette quantité de charges est importante cela impose un registre de grande taille, donc une puissance de phases de commande élevée et des couplages entre phases de commande importants ;

— la résolution verticale à bas niveau de lumière.

La présente invention cherche aussi à assurer un transfert efficace des charges parasites depuis les colonnes jusqu'au drain d'évacuation, sans perturber le transfert des charges-signal et sans utiliser de drains au niveau de la zone photosensible.

La présente invention concerne un procédé d'analyse d'un dispositif photosensible à transfert de ligne, ce dispositif comportant une zone photosensible de M lignes de N points photosensibles, les points photosensibles des différentes lignes étant reliés en parallèle par des colonnes conductrices à une mémoire qui assure le transfert vers un registre de lecture des charges-signal d'une même ligne et qui assure le transfert vers un drain d'évacuation des charges-parasites se trouvant sur les colonnes avant l'arrivée des charges-signal.

Dans ce cas, il est connu de réaliser l'analyse de chaque ligne de la zone photosensible en transférant les charges-signal vers la mémoire, en superposant aux charges-signal au moins une première charge d'entraînement stockée en mémoire et transférée sur les colonnes avant l'arrivée des charges-signal. Selon une caractéristique de l'invention, cette première charge d'entraînement est suffisante pour permettre de passer en forte inversion au début du transfert des colonnes vers la mémoire et une deuxième charge d'entraînement, au moins suffisante pour permettre de passer en forte inversion au début du transfert, est superposée aux charges-signal lors du transfert vers le registre de lecture, cette deuxième charge d'entraînement étant lue avec les charges-signal.

Selon une autre caractéristique de l'invention, lorsque, pour l'évacuation des charges-parasites se trouvant sur les colonnes avant l'arrivée des charges-signal, le transfert des charges-parasites des colonnes vers la mémoire est réalisé en leur superposant la même première charge d'entraînement que pour les charges-signal, le transfert ayant la même durée que le transfert des charges-signal des colonnes vers la mémoire et la première charge d'entraînement étant toujours stockée en mémoire et transférée périodiquement sur les colonnes ; l'on réalise le transfert des charges-parasites de la mémoire vers le drain en leur superposant une troisième charge d'entraînement au moins suffisante pour permettre de passer en forte inversion au début du transfert, ce transfert ayant la même durée que le transfert des charges-signal de la mémoire vers le registre de lecture, et cette troisième charge d'entraînement étant évacuée avec les charges-parasites vers le drain.

D'autres objets, caractéristiques et résultats de l'invention ressortiront de la description suivante donnée à titre d'exemple non limitatif et illustrée par les figures annexées dans lesquelles :

les figures 1 et 2 sont des schémas illustrant deux procédés d'analyse selon l'art antérieur d'un dispositif photosensible à transfert de ligne ;

la figure 3 est une courbe montrant comment s'effectue dans le procédé de la figure 2, le transfert des charges-signal des capacités intermédiaires de la mémoire vers le registre de lecture ;

la figure 4 est un schéma illustrant le procédé d'analyse selon l'invention ;

les figures 5 et 6 sont des courbes montrant comment s'effectuent, dans le procédé selon l'invention, les transferts des charges des colonnes vers les capacités intermédiaires et des capacités intermédiaires vers le registre de lecture ;

la figure 7 est un schéma d'un dispositif de mise en œuvre du procédé selon l'invention ;

les figures 8(a) à (k) sont une vue en coupe transversale du dispositif de la figure 7 et des schémas expliquant son fonctionnement ;

la figure 9 est un schéma d'un deuxième mode de réalisation de l'injection de la troisième charge d'entraînement conformément à la présente invention ;

les figures 10(a) à (k) sont une vue en coupe transversale du dispositif de la figure 9 et des schémas expliquant son fonctionnement ;

la figure 11 est un schéma partiel d'un troisième mode de réalisation de l'injection de la troisième charge d'entraînement conformément à la présente invention ;

les figures 12(a) et 12(b) sont une vue en coupe transversale par A-A de figure 11 et un schéma expliquant son fonctionnement ;

la figure 13 est un schéma d'un autre mode de réalisation de l'étage d'entrée du dispositif de la figure 11 ;

la figure 14 est un schéma partiel d'un quatrième mode de réalisation de l'injection de la troisième charge d'entraînement conformément à la présente invention ;

la figure 15 est un schéma partiel d'un cinquième mode de réalisation de l'injection de la troisième charge d'entraînement conformément à la présente invention ;

la figure 16 est un diagramme des temps des phases appliqués sur le registre utilisé dans la figure 15.

Sur les différentes figures, les mêmes repères désignent les mêmes éléments, mais pour des raisons de clarté, les cotes et proportions des divers éléments ne sont pas respectées.

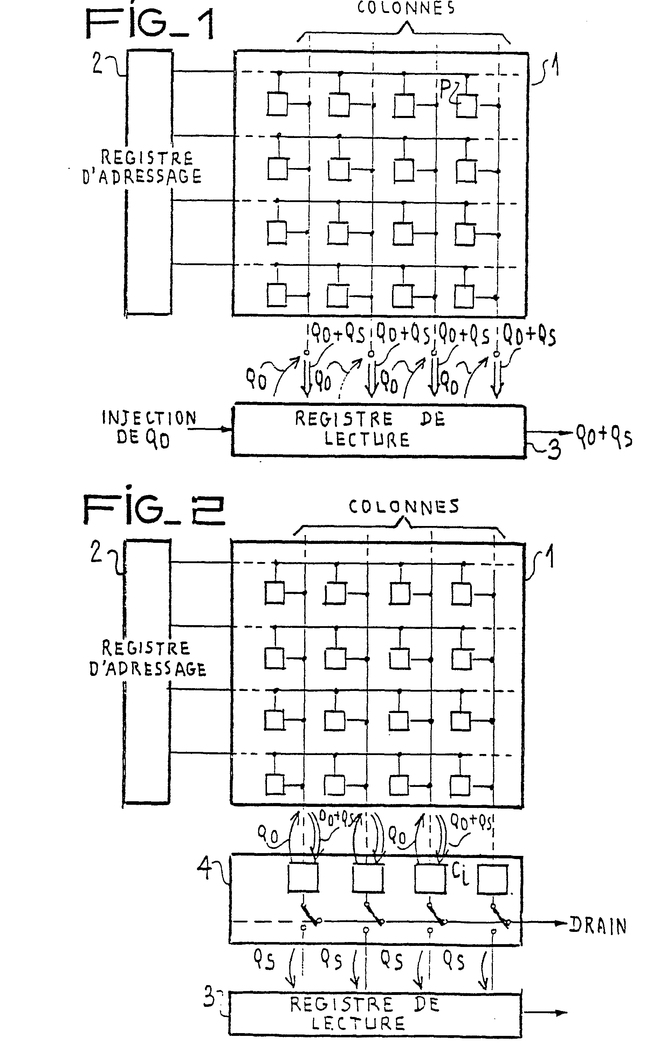

La figure 1 est un schéma illustrant un procédé d'analyse d'un dispositif photosensible à transfert de ligne selon l'art antérieur. Ce procédé est décrit dans l'article paru dans la revue I.E.E.E. Journal of Solid State Circuits, volume SC 15, n° 2, Avril 1980, page 206.

Sur la figure 1 on a représenté schématiquement une zone photosensible 1, constituée d'une matrice de M lignes comportant chacune N points photosensibles P. Cette zone reçoit l'image lumineuse à analyser et la transforme en charges électriques, dites charges-signal. Les points photosensibles d'une même ligne sont reliés entre eux et reliés à un registre d'adressage 2 qui permet de sélectionner une ligne de la matrice. Les points photosensibles d'une même colonne sont reliés à une même colonne conductrice.

Les charges-signal créées dans chacun des points photosensibles d'une même ligne sont transférées en parallèle vers un registre de lecture 3 qui fournit l'information reçue en parallèle, en mode série. Cette information constitue le signal vidéo d'analyse de l'image optique reçue dans la zone photosensible 1. Le registre est de préférence à transfert de charge, de type C.C.D.

Dans l'art antérieur constitué par exemple par les deux demandes de brevet citées, on a montré que l'on améliore l'efficacité du transfert en superposant une charge d'entraînement $Q_0$ à chaque charge-signal $Q_S$ ; cette amélioration est surtout sensible lorsque la charge-signal est de faible amplitude.

Dans l'article d'I.E.E.E. déjà cité, la charge d'entraînement est fournie par le registre de lecture lui-même. Dans ce cas, il y a en permanence injection d'une quantité de charges $Q_0$ dans le registre. La charge d'entraînement $Q_0$ est transférée sur chacune des colonnes avant l'arrivée de la charge-signal sur la colonne, comme cela est symbolisé sur la figure 1 par une flèche allant du registre vers chaque colonne. Puis l'ensemble $Q_S + Q_0$, charge-signal plus charge d'entraînement, est transféré depuis chaque colonne jusqu'au registre de lecture et de là en série vers la sortie. Le transfert de $Q_S + Q_0$ des colonnes vers le registre est symbolisé par une double flèche sur la figure.

Les inconvénients de ce procédé d'analyse d'un dispositif photosensible à transfert de ligne sont les suivants.

Compte tenu de la capacité relativement importante des colonnes lorsque le nombre de lignes est grand, la charge d'entraînement $Q_0$ doit être importante devant la charge-signal maximum. Par exemple, la capacité des colonnes est d'environ 3 pf pour 625 lignes, ce qui conduit à utiliser une charge d'entraînement $Q_0$ d'environ 1 pc pour une charge-signal maximum de 0,2 pc. Ceci a deux conséquences néfastes :

— en sortie du registre de lecture, on obtient $Q_S + Q_0$ et non $Q_S$ seulement. Le bruit temporel est alors dominé par le bruit dû à la charge $Q_0$. Il n'est pas possible d'injecter une charge élevée dans un registre à transfert de charge sans lui superposer un bruit lié à la capacité d'entrée du registre et à la méthode d'injection. La capacité d'entrée du registre, et donc le bruit associé, sont d'autant plus importants que $Q_0$ est élevée. La charge d'entraînement $Q_0$ étant importante, on perd l'un des avantages du transfert de ligne qui est de permettre une lecture à faible bruit ;

— de plus, il faut véhiculer dans le registre de lecture non pas $Q_S$, mais $Q_S + Q_0$. Il faut donc un registre de taille plus importante, ainsi qu'une puissance de phase de commande plus élevée et des couplages entre phases de commande plus importants.

Un autre inconvénient du procédé illustré par la figure 1 est que l'évacuation des charges parasites dues à la diaphotie (ou « smearing ») ou à l'éblouissement (ou « blooming ») ne peut être réalisée que par des drains situés près des points photosensibles.

La Demanderesse considère qu'il est préférable que la lecture des charges parasites, comme celle des charges-signal, s'effectue à l'aide d'une charge d'entraînement $Q_0$.

Or l'on ne dispose que d'une seule quantité de charge $Q_0$ pour chaque colonne ; puisque $Q_0$ est transférée vers la sortie avec les charges-signal, il n'est pas possible de disposer d'une charge d'entraînement $Q_0$ pour lire les charges parasites. Il faudrait donc utiliser des drains situés au niveau de chaque point photosensible.

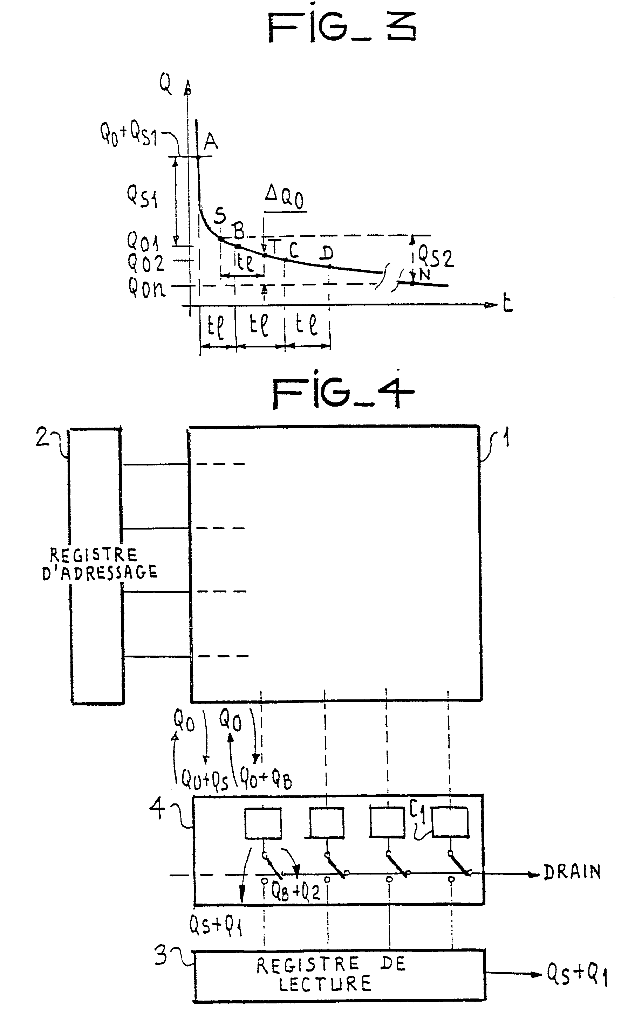

La figure 2 est un schéma illustrant un autre procédé d'analyse d'un dispositif photosensible à transfert de ligne selon l'art antérieur. Ce procédé est décrit dans le brevet français n° 2.504.334.

L'examen de la figure 2 montre, par rapport à la figure 1, la présence entre la zone photosensible 1 et le registre de lecture 3 d'une mémoire de ligne 4. Cette mémoire comporte une série de capacités intermédiaires $C_1$, chaque capacité étant reliée d'une part à une colonne et d'autre part à des moyens de commutation symbolisés par des interrupteurs I et conduisant le contenu des capacités intermédiaires soit vers un drain d'évacuation, soit vers le registre de lecture.

Selon ce procédé, une quantité de charge d'entraînement $Q_0$ est stockée dans chaque capacité intermédiaire. Cette quantité de charge d'entraînement est transférée sur les colonnes avant l'arrivée des charges-signal $Q_S$, ensuite la quantité de charge $Q_S + Q_0$ est transférée dans chaque capacité intermédiaire. Ces deux séries de transferts sont représentées symboliquement par des flèches sur la figure 2.

Il est possible de transférer les quantités de charge $Q_0 + Q_S$ dans le registre de lecture mais on préfère généralement n'y transférer que les quantités de charge $Q_S$ ce qui permet d'éliminer le bruit dit spatial existant sur $Q_0$ d'une colonne à l'autre et ce qui permet de ne pas surcharger le registre de lecture. Le transfert depuis chaque capacité intermédiaire jusqu'au registre de lecture doit donc s'effectuer de façon à laisser en arrière la quantité de charge $Q_0$. Ceci est réalisé par une barrière de potentiel qui laisse passer seulement les charges-signal $Q_S$ en excès par rapport à $Q_0$.

La figure 3 montre comment s'effectue au cours du temps t le transfert des charges depuis chaque capacité intermédiaire vers le registre de lecture. La caractéristique Q(t) de la figure 3 montre donc la décharge en fonction du temps t des capacités intermédiaires. Cette caractéristique comporte une partie sensiblement verticale, un coude, puis une partie sensiblement horizontale.

Le transfert s'effectue d'abord en forte inversion puis en faible inversion.

Soit une quantité de charge-signal $Q_{S1}$, telle qu'une capacité intermédiaire contienne une quantité de charge $Q_0 + Q_{S1}$ portant son point de fonctionnement au point A de la caractéristique Q(t) de la figure 3, c'est-à-dire sur la partie sensiblement verticale de cette caractéristique. Après le temps de lecture $t_1$, la charge $Q_{S1}$ a été transférée dans le registre de lecture. Le point de fonctionnement de la capacité est au point B de la caractéristique, c'est-à-dire dans le coude de la caractéristique et cette capacité ne renferme plus qu'une charge $Q_{01}$ peu différente de $Q_0$. Le transfert de $Q_{S1}$ a été efficace car il s'est effectué en forte inversion.

La Demanderesse a mis en évidence que le procédé de la figure 3 présente l'inconvénient suivant.

Lorsque les quantités de charge-signal qui sont lues ont des valeurs sensiblement égales à $Q_{S1}$, le point de fonctionnement sur la caractéristique de la figure 3 se déplace entre deux points proches du point A et du point B. Le transfert de $Q_{S1}$ est efficace car il s'effectue en forte inversion.

En fait, la valeur des capacités intermédiaires étant faible, cela se traduit par une caractéristique Q(t) présentant une partie sensiblement verticale. Il suffit donc d'une charge-signal $Q_S$ de faible valeur — de l'ordre de 0,05 pc, par exemple — pour que le point A se trouve sur la partie verticale de la caractéristique et que le transfert soit efficace et s'effectue en forte inversion.

Par contre le procédé de la figure 3 devient très peu performant lorsqu'il faut traiter des lignes qui sont très peu ou pas éclairées.

En l'absence d'éclairement, le transfert vers le registre de lecture s'effectue, toujours pendant un temps $t_1$, mais à partir du point B jusqu'au point C où la charge d'entraînement se trouve réduite à la valeur $Q_{02}$ telle que : $Q_{02} < Q_{01}$. Si plusieurs lignes successives sont dépourvues de signal, le point de fonctionnement va successivement passer de C en D, ... puis en N. La charge d'entraînement est peu à peu réduite et passe de $Q_{01}$ à $Q_{02}$ puis à $Q_{0N}$. Le transfert en faible inversion qui se produit à chaque lecture de lignes non éclairées finit par creuser une « poche » importante dans la charge d'entraînement $Q_0$. La prochaine charge-signal qui suivra les lignes noires devra combler cette poche avant de pouvoir être transférée. Le transfert de cette charge-signal s'effectuera donc en faible inversion avec une efficacité de transfert très détériorée.

Supposons en effet une charge-signal $Q_{S2}$ qui fasse passer le point de fonctionnement de N en S. Le transfert pendant le temps $t_1$ conduit du point S au point T.

La charge transférée dans le registre en passant du point S au point T s'écrit :

$$Q(t_S) - Q(t_T) = Q_{S2} + Q_{0N} - Q(t_T)$$

Posons : $Q(t_T) = Q_{0N} + \Delta Q_0$, l'inefficacité de transfert s'exprime :

$$\varepsilon = \frac{\Delta Q_0}{Q_{S2}}$$

Sur la figure 3, on voit graphiquement que $\varepsilon$ peut être supérieur à 50 %.

Le procédé de l'art antérieur illustré par la figure 3 produit donc une dégradation importante de la résolution verticale d'autant plus sensible qu'on se trouve à plus bas niveau de lumière.

Un autre inconvénient du procédé illustré par la figure 2 est que, comme pour le procédé de la figure 1, l'évacuation des charges parasites dues à la diaphotie ou à l'éblouissement ne peut être réalisée que par des drains situés près des points photosensibles.

Dans le procédé de la figure 2, la charge d'entraînement $Q_0$ qui est stockée dans les capacités intermédiaires pourrait a priori être utilisée pour transférer les charges parasites $Q_B$ puis les charges-signal $Q_S$ des colonnes dans les capacités intermédiaires. La conservation de $Q_0$ dans les capacités intermédiaires se fait en utilisant une barrière de potentiel qui laisse passer seulement les charges en excès par rapport à $Q_0$.

La Demanderesse a constaté que la conservation de $Q_0$ dans les capacités intermédiaires lors des transferts des charges-signal et des charges parasites des capacités intermédiaires vers le registre de lecture pose les deux problèmes suivants :

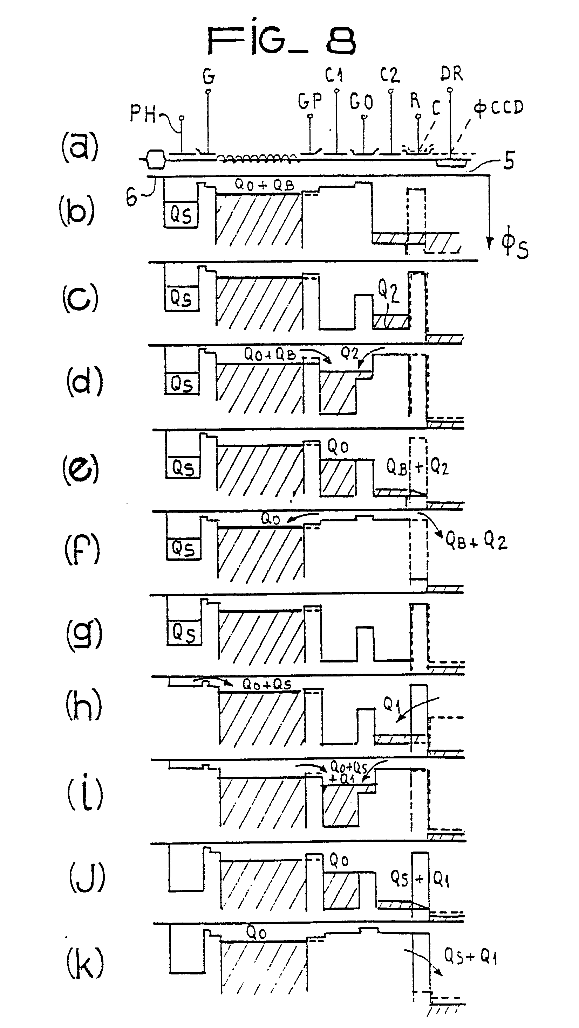

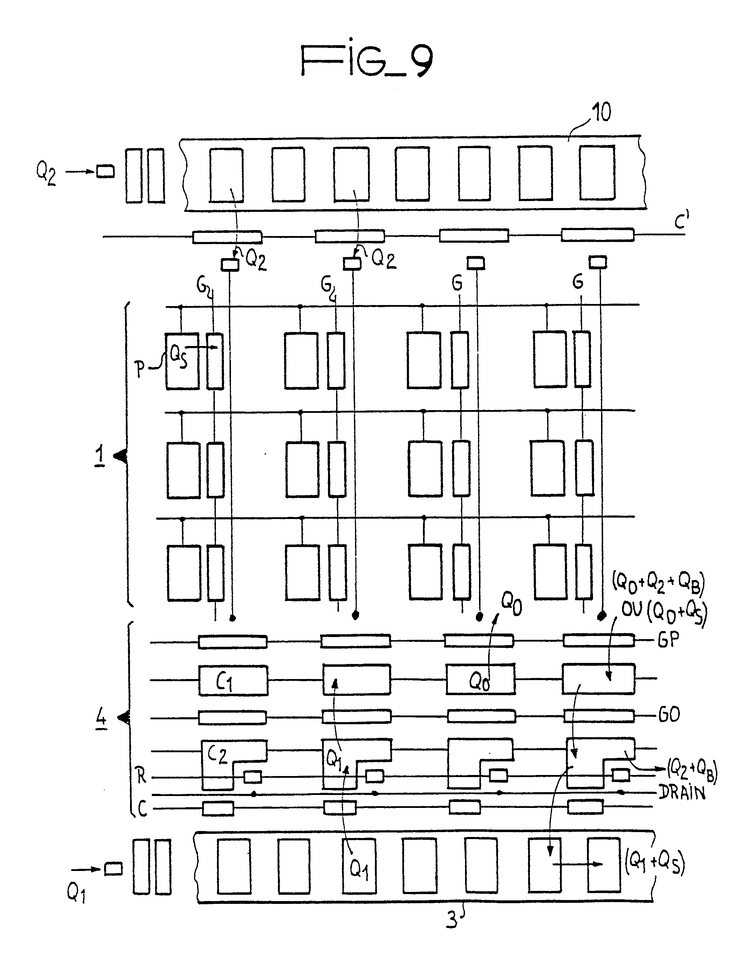

— il faut deux barrières de potentiels pour retenir $Q_0$ dans les capacités intermédiaires, alors que des charges sont transférées soit vers le drain, soit vers le registre de lecture. Il est pratiquement impossible d'obtenir l'égalité rigoureuse de ces deux barrières. La solution de ce problème consiste à utiliser une mémoire de ligne à double étage, telle que celle qui est décrite dans le brevet français n° 2.504.334 et qui est représentée sur les figures 8 et 9 de ce brevet.

— la figure 3 et son commentaire ont montré les problèmes qui se posent lors du transfert des charges-signal des capacités intermédiaires vers le registre de lecture, en retenant $Q_0$ dans les capacités intermédiaires et ceci lorsque l'on traite des lignes qui sont très peu ou pas éclairées. Lorsque les charges-parasites sont transférées des capacités intermédiaires vers le registre de lecture, $Q_0$ étant retenue dans les capacités intermédiaires, on a alors le problème suivant. On a vu qu'en l'absence d'éclairement, le transfert s'effectue toujours vers le registre de lecture, pendant un temps $t_1$ et que la charge d'entraînement est alors réduite. L'arrivée des charges parasites ne permet pas forcément de repasser en forte inversion, mais permet de redonner à la charge d'entraînement une valeur plus ou moins proche de $Q_0$ selon la quantité de charges parasites qui est transférée. Si la prochaine quantité de charges-signal à transférer est sensiblement nulle, on lit quand même une quantité de charge qui est pratiquement proportionnelle à la quantité de charges parasites lue précédemment et qui a plus ou moins restauré $Q_0$. On a donc une très mauvaise efficacité pour l'élimination des charges parasites.

La figure 4 est un schéma illustrant le procédé d'analyse d'un dispositif photosensible à transfert de ligne selon l'invention.

Comme dans le procédé de la figure 2, une quantité de charge d'entraînement $Q_0$ est stockée en mémoire dans chaque capacité intermédiaire et transférée sur les colonnes avant l'arrivée des charges-signal $Q_S$. Ensuite la quantité de charge $Q_0 + Q_S$ est transférée dans chaque capacité intermédiaire, et ainsi de suite à chaque lecture.

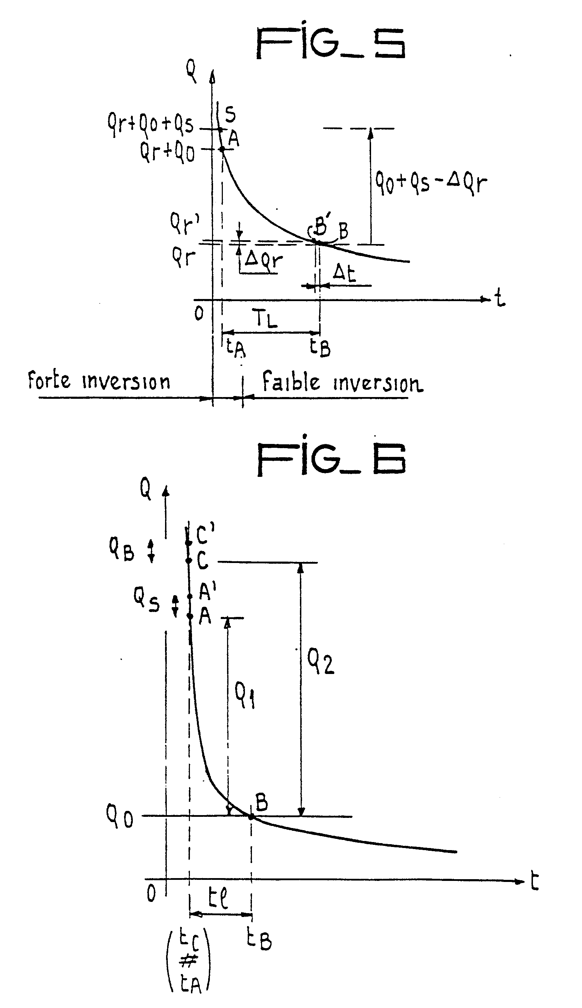

La figure 5 montre comment s'effectue au cours du temps le transfert des charges depuis les colonnes jusqu'aux capacités intermédiaires. Cette caractéristique Q(t) présente un coude beaucoup moins prononcé que la caractéristique de la figure 3 car la capacité des colonnes est beaucoup plus importante — environ dix fois plus importante — que celle des capacités intermédiaires.

Supposons qu'il n'y ait pas de charge-signal à transférer des colonnes vers la mémoire, le point de fonctionnement se trouve alors au point A de la courbe de la figure 5. La charge à transférer égale : $Q_0 + Q_r$, avec $Q_0$ la charge d'entraînement stockée dans les capacités intermédiaires et $Q_r$ une charge résiduelle.

Après un temps de lecture $T_L$, le point de fonctionnement passe au point B. La charge $Q_0$ a été transférée dans une capacité intermédiaire. La charge de la colonne n'est plus que $Q_r$. Le retour de $Q_0$ sur la colonne préalable à une nouvelle lecture des charges-signal ramène le point de fonctionnement au point A. En l'absence de charges-signal à transférer, la charge des colonnes évolue à chaque lecture entre deux positions d'équilibre qui sont le point A, où la charge égale $Q_0 + Q_r$ et le point B, où la charge égale $Q_r$.

Lorsqu'une charge-signal $Q_S$ non nulle est transférée de la zone photosensible sur une colonne, le point de fonctionnement passe en S où la charge égale : $Q_0 + Q_r + Q_S$.

Après le temps de lecture $t_L$, le point de fonctionnement passe en un point B' très proche de B, où la charge égale $Q'_r$. Le point B' est très proche du point B car la pente de la caractéristique $Q_{(t)}$ est très élevée au point A et faible au point B.

Le fait que le point B' soit distinct du point B signifie qu'une quantité de charge $\Delta Q_r$ n'a pas été transférée.

La charge transférée sur une capacité intermédiaire alors que le point de fonctionnement passe de S en B' s'écrit :

$$\overbrace{Q_r + Q_0 + Q_S}^{\text{charge en S}} - \overbrace{Q'_r}^{\text{charge en B'}} = Q_0 + Q_S - \Delta Q_r.$$

avec $\Delta Q_r = Q'_r - Q_r$.

Or $\Delta Q_r$ peut aussi s'exprimer en fonction de $Q'(t_B)$, qui est la pente de la caractéristique au point B :

$$\Delta Q_r = \Delta t \cdot Q'(t_B) \tag{1}$$

où, $\Delta t$ est la projection du segment BB' sur l'axe des temps.

La projection du segment SA sur l'axe des temps égale aussi $\Delta t$, d'où la relation suivante faisant intervenir $\Delta t$ :

$$Q_S = \Delta t \cdot Q'(t_A) \tag{2}$$

5

où, $Q'(t_A)$ est la pente de la caractéristique au point A.

L'efficacité de transfert s'exprime donc à l'aide des relations (1) et (2) en fonction du rapport des pentes de la caractéristique aux points B et A :

$$\varepsilon = \frac{\Delta Q_r}{Q_S} = \frac{Q'(t_B)}{Q'(t_A)}$$

Pour obtenir une bonne efficacité de transfert, il faut que le point A soit dans une zone à forte pente, donc de forte inversion, et que le point B soit dans une zone à faible pente, donc de faible inversion.

Selon l'invention, l'amplitude minimum de la charge d'entraînement $Q_0$ doit être telle qu'elle permette de passer en forte inversion au début du transfert des colonnes vers la mémoire, même s'il n'y a pas de charges-signal à transférer. C'est la condition pour avoir une bonne efficacité de transfert des charges des colonnes vers la mémoire de ligne.

Cette quantité de charge $Q_0$ est d'autant plus grande que la capacité des colonnes est élevée.

En effet la pente de la partie gauche de la courbe de la figure 5 qui correspond à un fonctionnement en forte inversion décroît comme le carré de la capacité des colonnes. Enfin, pour une technologie donnée la capacité des colonnes croît avec le nombre de lignes à analyser.

Ceci explique donc la nécessité d'une charge d'entraînement $Q_0$ importante devant la valeur maximale des charges-signal si l'on veut obtenir une bonne efficacité de transfert lors de la lecture d'un dispositif photosensible comportant un nombre de lignes élevé, 625 lignes par exemple.

Par exemple, pour C colonnes $\simeq 3,5$ pf, il faut choisir une charge d'entraînement de l'ordre de 1 pc, alors que $Q_S$ est de l'ordre de 0,2 pC, pour un temps de lecture $T_L$ de l'ordre de 2 µs. On obtient alors une efficacité de transfert de l'ordre de 3 %.

Selon l'invention, le transfert des charges-signal de la mémoire dans le registre de lecture se fait en superposant aux charges-signal une charge d'entraînement $Q_1$. Cette charge $Q_1$ doit être choisie pour permettre de passer en forte inversion au début de chaque transfert des charges, de la mémoire vers le registre, même lorsqu'il n'y a pas de charges-signal à transférer et en tenant compte du fait que $Q_1$ se superpose à $Q_0$ stockée en mémoire. Ainsi est évitée la perte de résolution verticale qui se produit dans le procédé illustré par la figure 2 lorsqu'il n'y a pas de charges-signal à transférer.

La figure 6 représente la caractéristique $Q(t)$ pour le transfert de la mémoire dans le registre de lecture. La charge d'entraînement $Q_1$ permet de passer du point B (où la charge égale $Q_0$) au point A (où la charge égale $Q_0 + Q_1$) ou au point A' (où la charge égale $Q_0 + Q_1 + Q_S$) lorsqu'il y a une charge-signal à transférer. Les points A et A' sont situés dans une zone de forte inversion.

Ainsi après le temps de lecture $t_1$, le point de fonctionnement se retrouve sensiblement en B sans descendre au-delà en l'absence de signal.

La charge d'entraînement $Q_1$ doit être fournie à chaque lecture puisqu'elle se trouve lue avec les charges-signal.

Les charges d'entraînement $Q_1$ peuvent être fournies de différentes façons.

Ces charges peuvent être fournies par le registre de lecture. Dans ce cas, il y a en permanence injection d'une quantité de charges $Q_1$ dans le registre. Une charge d'entraînement $Q_1$ est alors transférée sur chaque capacité intermédiaire avant l'arrivée des charges-signal. Ainsi fournies, les quantités de charges $Q_1$ sont identiques et n'introduisent pas de bruit spatial supplémentaire.

Les charges d'entraînement $Q_1$ peuvent aussi être injectées sur chaque capacité intermédiaire à partir d'une diode associée à une grille d'injection. Dans ce cas, on peut craindre d'introduire un bruit spatial sur les quantités de charges $Q_1$.

Il est aussi possible d'injecter les charges d'entraînement $Q_1$ directement au niveau de la zone photosensible en utilisant la technique de l'éclairage en pluie. Dans ce cas, on dispose d'un éclairement uniforme qui génère en permanence dans les points photosensibles une charge $Q_1$ qui se superpose aux charges-signal et la charge d'entraînement $Q_1$ sera lue avec la charge-signal $Q_S$. Comme l'amplitude de la charge $Q_1$ est faible, le bruit quantique associé à sa génération est peu important. D'autre part, la présence de cette charge constante dans chaque point photosensible présente l'avantage d'améliorer le transfert du point photosensible vers la colonne et de supprimer la rémanence dans le cas où le point photosensible est constitué par une photodiode et un photo MOS.

Dans le cas d'un dispositif recouvert de filtres colorés, il importe que l'éclairement soit choisi de manière à être transmis de façon uniforme par les différents filtres. On peut utiliser par exemple un éclairement dans le proche infrarouge pour lequel les filtres colorés ont tous en général une transmission équivalente.

Les capacités intermédiaires ayant une valeur assez faible, il suffit d'une charge $Q_1$ relativement faible pour revenir en forte inversion à chaque lecture à partir, par exemple, du point B de la caractéristique $Q(t)$ de la figure 6. Typiquement, la charge d'entraînement $Q_1$ peut être de l'ordre de $Q_S$ max/10. où $Q_S$ max représente la valeur la plus élevée de la charge-signal. On a intérêt à choisir la charge d'entraînement $Q_1$ minimum qui permet de revenir en forte inversion à chaque lecture à partir du point B. Ainsi le bruit d'injection temporel associé à $Q_1$ est bien plus faible que celui qu'on trouve associé à la charge $Q_0$ transférée dans le registre de lecture dans le cas du procédé de la figure 1. On ne retrouve pas non plus l'inconvénient du procédé de la figure 1 en ce qui concerne la quantité de charge totale que doit véhiculer le registre de lecture car la charge d'entraînement $Q_1$ n'accroît que de 1/10e environ la dynamique du signal à transporter dans le registre de lecture.

Les charges parasites $Q_B$ introduites sur les colonnes par diaphotie ou suréclairement doivent être évacuées vers le drain avant l'arrivée des charges-signal.

La Demanderesse considère qu'il est préférable que le transfert des charges parasites $Q_B$ comme celui des charges-signal se fasse avec double charge d'entraînement.

En ce qui concerne le transfert des colonnes vers la mémoire, la même charge d'entraînement $Q_0$. qui est stockée dans la mémoire, est utilisée pour transférer les charges-signal et les charges-parasites. Ainsi on ne perturbe pas le potentiel d'équilibre des colonnes, c'est-à-dire le point B des caractéristiques des figures 5 et 6. De plus il faut que le temps de transfert $T_L$ soit le même pour les charges-signal et les charges-parasites.

En ce qui concerne le transfert des charges de la mémoire vers le drain ou vers le registre de lecture, on utilise une charge d'entraînement $Q_1$ pour transférer les charges-signal $Q_S$ et une charge d'entraînement $Q_2$ pour transférer les charges parasites $Q_B$.

Lorsque les transferts de la mémoire vers le drain ou vers le registre de lecture sont terminés, on doit se retrouver sensiblement au point B de la caractéristique de la figure 6 où la charge égale $Q_0$.

On a vu que la charge $Q_1$ était choisie pour permettre de passer en forte inversion au début de chaque transfert de charges de la mémoire vers le registre, même lorsqu'il n'y a pas de charges-signal à transférer. L'arrivée de $Q_1$ sur une capacité intermédiaire $C_i$ amène le point de fonctionnement au point A. Le transfert de $Q_S + Q_1$ pendant le temps $t_1$ ramène le point de fonctionnement au voisinage du point B.

La charge d'entraînement $Q_2$ est choisie, comme $Q_1$, pour permettre de passer en forte inversion au début de chaque transfert de charges, même s'il n'y a pas de charges-parasites à transférer.

L'arrivée de $Q_2$ porte le point de fonctionnement au point C, puis l'arrivée de $Q_B$ le porte au point C'. Le transfert de $Q_B + Q_2$ pendant le même temps $t_1$ que celui qui est utilisé pour transférer $Q_S + Q_1$ porte le point de fonctionnement au voisinage du point B. Par contre la charge $Q_2$ étant évacuée on n'a pas particulièrement intérêt à choisir, comme pour $Q_1$, la charge minimum permettant de revenir en forte inversion à chaque lecture à partir du point B.

Le point de fonctionnement obtenu à la suite du transfert des charges-signal et des charges parasites de la mémoire vers le drain ou le registre n'est pas rigoureusement le point B car les quantités $Q_S + Q_1$ et $Q_B + Q_2$ ne sont pas nécessairement les mêmes et car la pente de Q(t) aux points A' et C' n'est pas infinie. Cependant les capacités intermédiaires ayant des valeurs assez faibles, les pentes aux points A' et C' et les rapports $Q'(t_A)/Q'(t_B)$ et $Q'(t_C)/Q'(t_B)$, sont élevés et on se trouve donc ramené à proximité du point B donc avec une charge sur les colonnes qui est proche de $Q_0$.

Il résulte de ce qui précède qu'il serait préférable que les charges d'entraînement $Q_1$ et $Q_2$ soient égales, mais ce n'est pas absolument obligatoire. Cela dépend de la quantité du bruit spatial tolérée en sortie du dispositif.

Les charges $Q_2$ étant évacuées dans le drain, alors que les charges $Q_1$ sont lues avec le signal, les charges $Q_2$ peuvent être introduites de toutes les façons possibles, du moment que leur amplitude est suffisante pour repasser en forte inversion à chaque transfert à partir du point B.

La charge d'entraînement $Q_2$ peut être introduite dans la mémoire à partir du drain d'évacuation. Toutefois une telle méthode d'introduction des charges a en général pour conséquence une dispersion sur la valeur de la troisième charge d'entraînement de colonne à colonne de l'ordre de 20 %. D'autre part, l'inefficacité de transfert entre les capacités intermédiaires de la mémoire de ligne n'est pas nulle. On retrouve donc, superposée à la charge-signal, une charge résiduelle issue de la troisième charge d'entraînement affectée du bruit spatial éventuel lié à l'introduction de cette troisième charge-signal.

En conséquence, comme expliqué ci-après, d'autres méthodes peuvent être utilisées pour introduire la charge d'entraînement $Q_2$.

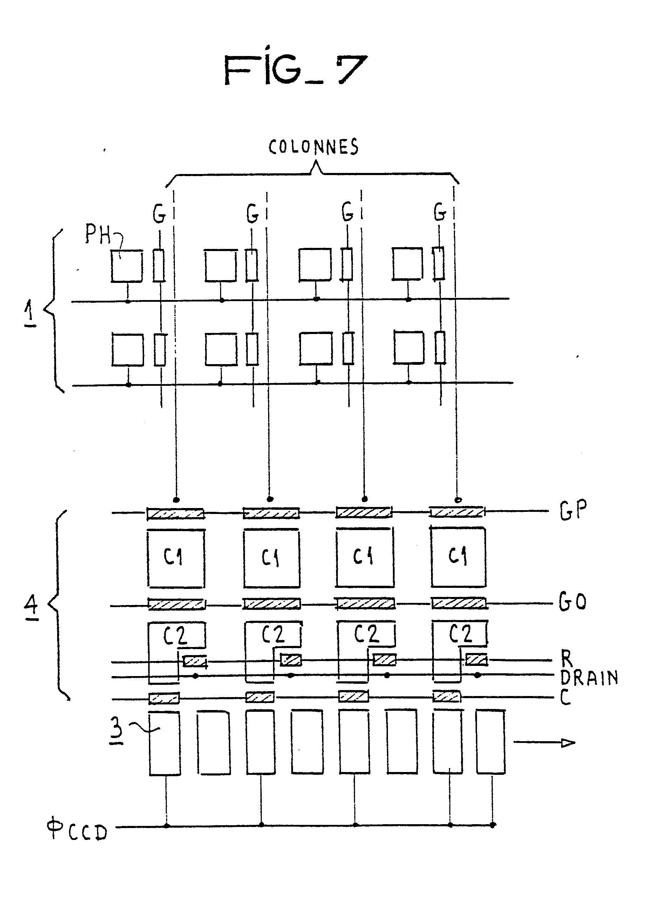

La figure 7 est un schéma d'un dispositif de mise en œuvre du procédé selon l'invention utilisant le drain d'évacuation pour l'introduction de la charge d'entraînement $Q_2$.

En haut de la figure 7, on a représenté la zone photosensible 1. Les points photosensibles sont disposés en matrice. Une grille G sépare chaque point photosensible des connexions de colonne. Cette grille permet d'isoler les points photosensibles du reste du dispositif durant l'intégration des charges.

Les colonnes conductrices aboutissent à une mémoire de ligne à double étage telle que celle qui est décrite dans le brevet français n° 2.504.334 et qui est représentée sur les figures 8 et 9 de ce brevet.

Cette mémoire comporte une série de capacités intermédiaires $C_1$ où se trouvent stockées les charges d'entraînement $Q_0$. Une grille $G_p$ contrôle le passage entre chaque colonne et une capacité intermédiaire. Le potentiel de cette grille fixe celui des colonnes.

Ces capacités intermédiaires sont suivies par des moyens de commutation qui conduisent le contenu des capacités intermédiaires soit vers un drain d'évacuation, soit vers le registre de lecture.

Sur la figure 7, on voit que les capacités intermédiaires $C_1$ sont suivies de grilles $G_0$ permettant de retenir les charges d'entraînement $Q_0$ dans les capacités intermédiaires et qui fixent leur amplitude. Les grilles $G_0$ sont suivies de capacités $C_2$ qui servent de plaques tournantes et permettent d'envoyer les charges venant de $C_1$ soit vers le drain d'évacuation, après passage d'une grille R, soit vers le registre de lecture 3, après passage d'une grille C. L'accès à chaque capacité $C_2$ est commandé par trois grilles, une grille $G_0$ qui permet l'arrivée des charges et deux grilles R et C qui permettent leur départ soit vers le drain, soit vers le registre de lecture.

Cette mémoire de ligne à double étage permet de retenir la charge d'entraînement $Q_0$ par une barrière de potentiel indépendante des organes d'aiguillage soit vers le drain, soit vers le registre de lecture.

La figure 8a est une vue en coupe transversale du dispositif de la figure 7. Elle est suivie de schémas montrant l'évolution du potentiel de surface $\emptyset_S$ dans le substrat semi-conducteur 5 sur lequel le dispositif photosensible est intégré, à divers instants, pris au cours d'une séquence de lecture ligne faite selon le procédé de l'invention. Les zones hachurées indiquent la présence de porteurs minoritaires. Sur les figures 8b à k, on n'a représenté que l'interface 6 du substrat et de la couche isolante qui le recouvre.

Sur la figure 8b, on voit que les points photosensibles sont en train d'intégrer des charges et contiennent une quantité de charges-signal $Q_S$. Sur les colonnes, on trouve la charge d'entraînement $Q_0$ et les charges parasites $Q_B$. Le drain impose un certain niveau des charges dans les capacités $C_2$.

Sur la figure 8c, la charge d'entraînement $Q_2$ se trouve isolée sous les capacités $C_2$ par le retour de la grille R au niveau bas.

Sur la figure 8d, s'opère le transfert des colonnes vers les capacités intermédiaires des charges parasites $Q_B$ et de la charge d'entraînement $Q_0$ grâce à l'augmentation du potentiel de la grille $G_p$. Ce transfert s'effectue pendant le temps $T_L$. Simultanément les capacités $C_2$ passent au niveau bas et les charges d'entraînement $Q_2$ sont transférés sur les capacités intermédiaires $C_1$.

Sur la figure 8e, s'opère le transfert de $Q_B + Q_2$ de $C_1$ vers $C_2$ puis vers le drain pendant le temps $t_1$. La capacité $C_2$ et la grille R sont alors au niveau haut. La charge d'entraînement $Q_0$ est retenue sous $C_1$ par $G_0$.

Sur la figure 8f, $C_1$ et $C_2$ passent au niveau bas. La charge $Q_0$ retourne sur les colonnes et la charge $Q_B + Q_2$ est complètement évacuée vers le drain.

Sur la figure 8g, $C_1$ et $C_2$ reviennent au niveau haut.

Sur la figure 8h, il y a transfert des charges-signal $Q_S$ des points photosensibles sur les colonnes où elles s'ajoutent aux charges $Q_0$. Simultanément, il y a transfert des charges d'entraînement $Q_1$ dans les capacités $C_2$. Ces charges proviennent du registre de lecture où elles ont été injectées en permanence pendant le temps ligne précédent. C'est le passage au niveau haut de la grille C qui permet leur transfert dans $C_2$.

Sur la figure 8i, le passage de la grille $G_p$ au niveau haut permet le passage de $Q_0 + Q_S$ dans $C_1$ pendant un temps $T_L$.

D'autre part, le passage de $C_2$ au niveau bas provoque le transfert de $Q_1$ sous $C_1$.

Sur la figure 8j, le passage de $C_2$ et de la grille C au niveau haut permet le passage de $Q_S + Q_1$ de $C_1$ vers $C_2$ pendant le temps $t_1$ puis vers le registre. La charge $Q_0$ est retenue sous $C_1$ par la grille $G_0$.

Sur la figure 8k, le passage de $C_1$ et $C_2$ au niveau bas provoque le retour de $Q_0$ sur les colonnes et le transfert complet de $Q_S + Q_1$ dans le registre.

Sur les colonnes, à la charge $Q_0$ vont venir s'ajouter les charges parasites $Q_B$ et l'on se retrouve alors dans la situation de la figure 8b.

Les étapes représentées sur les figures 8b à k ont lieu de préférence pendant le temps de retour ligne.

Avec le dispositif représenté à la figure 7, il est possible d'utiliser un autre procédé que celui décrit ci-dessus pour générer les deuxième et troisième charges d'entraînement $Q_1$ et $Q_2$.

Ainsi la deuxième charge d'entraînement $Q_1$ peut être obtenue en utilisant la technique de l'éclairage en pluie, la troisième charge d'entraînement $Q_2$ étant obtenue en injectant en continu ladite charge dans le registre de lecture 3. Dans ce cas, la deuxième charge d'entraînement $Q_1$ est générée en permanence grâce à un éclairement uniforme au niveau des points photosensibles où elle se superpose à la charge-signal. Cette deuxième charge d'entraînement est donc lue avec la charge-signal $Q_S$. En ce qui concerne le fonctionnement, il est identique à celui décrit avec référence à la figure 8 lorsqu'il s'agit du transfert des charges $Q_B + Q_2$ ou $Q_S + Q_0 + Q_1$ mais il diffère légèrement dans les procédés utilisés pour superposer la troisième charge d'entraînement $Q_2$ à la charge parasite $Q_B$ et la deuxième charge d'entraînement $Q_1$ à la charge-signal $Q_S$. En effet dans ce cas, la deuxième charge d'entraînement $Q_1$ est superposée à la charge-signal $Q_S$ au niveau du point photosensible et c'est l'ensemble $Q_S + Q_1$ qui est transféré du point photosensible sur la colonne correspondante où il s'ajoute à la charge $Q_0$.

De plus la troisième charge $Q_2$ est transférée du registre de lecture 3 vers la capacité $C_2$, la grille R étant au niveau bas et la grille C étant au niveau haut au lieu d'être imposée par le niveau dans le drain.

La figure 9 est un schéma d'un autre mode de réalisation d'un dispositif de mise en œuvre du procédé de la présente invention utilisant un registre CCD pour l'injection de la troisième charge d'entraînement $Q_2$.

Sur cette figure, la zone photosensible 1, la mémoire de ligne 4 et le registre de lecture 3 sont identiques à ceux de la figure 7. En conséquence, ils ne seront pas redécrits en détail.

Toutefois, conformément au mode de réalisation représenté, un registre à décalage 10 de type CCD à entrée série et sorties parallèles est positionné parallèlement aux lignes de la matrice photosensible sur le côté opposé au registre de lecture 3. Ce registre 10 est séparé de la matrice photosensible par des grilles C' qui règlent le moment du transfert des charges $Q_2$ vers les colonnes de la matrice photosensible. La troisième charge d'entraînement $Q_2$ est injectée en continu dans le registre à décalage 10 par l'intermédiaire d'un étage d'injection de type connu constitué par une diode et des grilles.

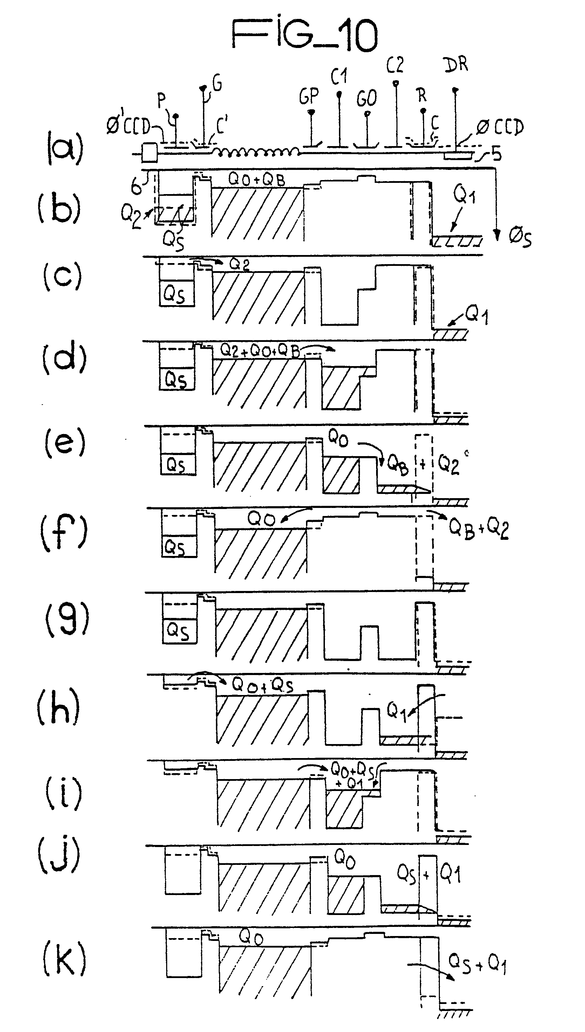

On expliquera le fonctionnement de ce mode de réalisation avec référence aux figures 10(a) à 10(k). La figure 10(a) est une vue en coupe transversale du dispositif de la figure 9. On a représenté en tiretés un étage de stockage du registre à décalage 10 et un étage de stockage du registre de lecture 3, ces étages étant référencés respectivement par $\emptyset'_{C.C.D}$ et $\emptyset_{C.C.D}$.

Les figures 10(b) à 10(k) sont des schémas montrant l'évolution du potentiel de surface $\emptyset_5$ dans le substrat semi-conducteur 5 sur lequel est intégré le dispositif photosensible, à divers instants pris au cours d'une séquence de lecture ligne faite selon le procédé de l'invention. Les zones hachurées indiquent la présence de porteurs minoritaires. Sur les figures 10(b) à 10(k), on a représenté uniquement l'interface 6 du substrat et de la couche isolante qui le recouvre.

Conformément à la présente invention, pendant le temps ligne durant lequel s'effectue la sortie série du signal vidéo dans le registre de lecture 3, les deuxième et troisième charges d'entraînement $Q_1$ et $Q_2$ sont injectées en série dans les registres à transfert de charge 3 et 10 de sorte qu'à la fin du temps ligne, on trouve des charges $Q_1$ et $Q_2$ sur les sorties parallèles des registres ci-dessus.

De ce fait, au début du temps de retour ligne, on se trouve dans l'état représenté à la figure 10(b). Sur cette figure on a représenté par $Q_S$ les charges-signal intégrées au niveau de chaque point photosensible. De plus, la première charge d'entraînement $Q_0$ et les charges parasites $Q_B$ sont positionnées sur les colonnes et les charges $Q_2$ et $Q_1$ se trouvent dans les étages correspondants des registres à décalage 10 et 3.

Comme représenté sur la figure 10(c), la charge $Q_2$ est transférée du registre à décalage 10 vers les colonnes où se trouve la charge d'entraînement principale $Q_0$. Pour ce faire, la grille C' est positionnée à un niveau haut et le potentiel $\emptyset_{C.C.D}$ est positionné à un niveau bas.

Ensuite, comme représenté sur la figure 10(d), l'ensemble des charges $Q_0$ représentant la première charge d'entraînement, $Q_2$ représentant la troisième charge d'entraînement et $Q_B$ représentant les charges parasites telles que les charges d'éblouissement par exemple est transféré sur les colonnes vers la capacité intermédiaire $C_1$ grâce à l'augmentation du potentiel de la grille $G_p$. Simultanément, les capacités $C_2$ passent au niveau bas et les charges d'entraînement $Q_2$ ainsi que les charges parasites $Q_B$ sont transférées vers la capacité $C_2$ puis vers le drain DR, le potentiel de la grille R se trouvant à un niveau haut, tandis que la charge $Q_0$ est maintenue dans la capacité $C_1$ par la barrière de potentiel créée sous la grille $G_0$, comme représenté sur la figure 10(e).

Comme représenté sur la figure 10(f), les capacités $C_1$ et $C_2$ passent au niveau bas. De ce fait, la charge $Q_0$ retourne sur les colonnes et la charge $Q_B + Q_2$ est complètement évacuée vers le drain DR.

Sur la figure 10(g), les capacités $C_1$ et $C_2$ reviennent au niveau haut et le potentiel de la grille R est ramené au niveau bas.

Ensuite, comme représenté sur la figure 10(h), il y a transfert des charges $Q_S$ des points photosensibles sur les colonnes où elles s'ajoutent aux premières charges d'entraînement $Q_0$. Simultanément les deuxièmes charges d'entraînement $Q_1$ stockées dans les étages de stockage du registre de lecture 3 sont transférées dans les capacités $C_2$ lors du passage au niveau haut de la grille C.

Puis, comme représenté sur la figure 10(i), le passage de la grille $G_p$ au niveau haut permet le passage des charges $Q_0 + Q_S$ dans les capacités intermédiaires $C_1$.

D'autre part, le passage de la capacité $C_2$ au niveau bas provoque le transfert des deuxièmes charges d'entraînement $Q_1$ sous les capacités intermédiaires $C_1$.

Comme représenté sur la figure 10(j), le passage des capacités $C_2$ et de la grille C au niveau haut permet le passage des charges $Q_S + Q_1$ de la capacité $C_1$ vers la capacité $C_2$ puis vers le registre de lecture 3. La charge $Q_0$ est retenue sous les capacités intermédiaires $C_1$ par la grille $G_0$.

Sur la figure 10(k) le passage des capacités $C_1$ et $C_2$ au niveau bas provoque le retour de la première charge d'entraînement $Q_0$ sur les colonnes et le transfert de $Q_S + Q_1$ dans le registre de lecture conformément au procédé décrit avec référence aux figures 8.

Sur les colonnes, à la charge $Q_0$ vont venir s'ajouter les charges parasites $Q_B$ et l'on se retrouve alors dans la situation de la figure 10(b).

Les étapes représentées sur les figures 10(b) à 10(k) ont lieu de préférence pendant le temps de retour ligne.

Les deuxième et troisième charges d'entraînement $Q_1$ et $Q_2$ étant injectées en série dans des registres à décalage du type C.C.D., elles se trouvent de ce fait exemptes de bruit spatial, ce qui ne pouvait être réalisé lorsque la troisième charge d'entraînement $Q_2$ était obtenue à l'aide du drain.

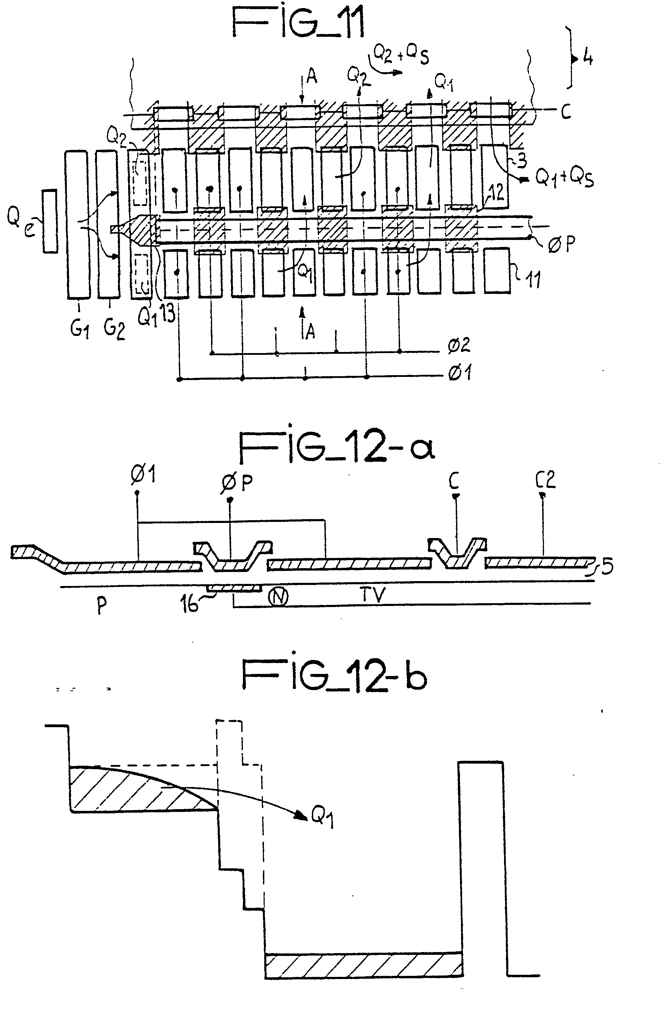

Les figures 11 à 13 représentent un autre mode de réalisation du dispositif d'injection des deuxième et troisième charges d'entraînement conformément à la présente invention. Ce dispositif d'injection est plus particulièrement intéressant dans le cas où le dispositif photosensible du type à transfert de ligne comporte deux ensembles registre de lecture-mémoire de ligne situés l'un au-dessus l'autre au-dessous de la matrice photosensible, permettant de lire alternativement les colonnes paires et impaires de cette matrice, comme décrit, par exemple, dans le brevet français 2.503.502. Toutefois, il est évident pour l'homme de l'art que ce dispositif peut aussi être utilisé dans le cas d'un seul ensemble registre de lecture-mémoire de ligne comme décrit avec référence aux figures 9 et 10.

Comme représenté sur la figure 11 dans laquelle on a omis dans un but de simplification la matrice photosensible 1 et référencé uniquement par 4 la mémoire de ligne, les dispositifs d'injection des seconde et troisième charges d'entraînement $Q_1$ et $Q_2$ sont constitués respectivement par le registre de lecture 3 et par un registre à transfert de charge auxiliaire 11 positionné parallèlement au registre de lecture 3 et à côté de celui-ci. Les deux registres 3 et 11 sont commandés par des phases communes $\emptyset_1$ et $\emptyset_2$ et communiquent au niveau de chaque phase $\emptyset_1$ par l'intermédiaire d'une grille de passage $\emptyset_P$. Des diffusions d'isolement 12 sont prévues entre les deux registres 3 et 11 au niveau des phases $\emptyset_2$.

D'autre part, comme représenté de manière plus détaillée sur la figure 12(a) qui est une vue en coupe transversale selon A-A de la figure 11, le registre de lecture est du type transfert en volume tandis que le registre auxiliaire 11 est du type transfert en surface. Ceci permet d'avoir des potentiels plus faibles dans le registre auxiliaire que dans le registre de lecture pour une même tension appliquée $\emptyset_1$ et permet en conséquence le transfert des charges stockées dans le registre auxiliaire de celui-ci vers le registre de lecture en portant seulement le potentiel de la grille $\emptyset_P$ au niveau haut comme cela sera expliqué plus en détails ci-après. De plus, pour bien séparer les deux canaux de transfert des charges des registres 3 et 11, une diffusion d'isolement 16 est prévue sous la grille $\emptyset_P$.

Comme représenté sur la figure 11, les deuxième et troisième charges d'entraînement $Q_2$ et $Q_1$ sont obtenues en injectant une charge unique $Q_e$ dans l'étage d'entrée et en partageant cette charge $Q_e$ en deux parties égales $Q_1$ et $Q_2$ à l'aide d'une diffusion d'isolement 13 selon le procédé décrit dans le brevet français n° 2.404.281.

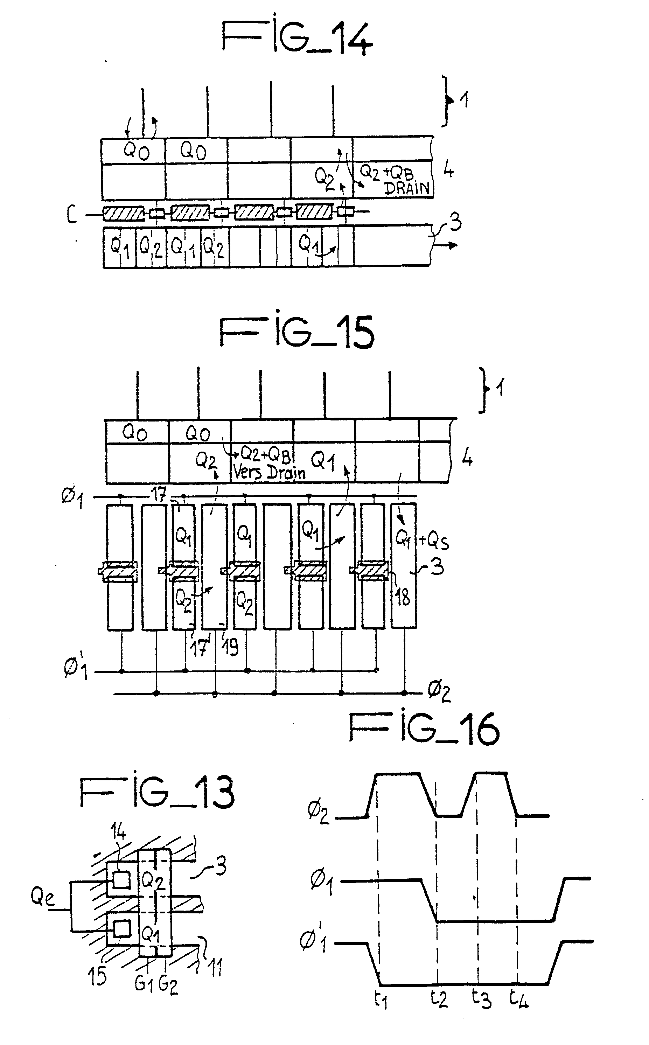

Comme représenté sur la figure 13, les charges $Q_1$ et $Q_2$ peuvent être obtenues à partir de deux étages d'injection indépendants 14, 15 l'un pour $Q_1$ l'autre pour $Q_2$.

On expliquera maintenant le fonctionnement de ce mode de réalisation avec référence en particulier aux figures 11 et 12.

Pendant le temps ligne, les charges $Q_1$ et $Q_2$ sont injectées en série sur chaque étage des deux registres adjacents 3 et 11. La charge d'entraînement $Q_2$ étant tout d'abord utilisée pour l'évacuation des charges parasites, elle sera injectée dans le registre de lecture 3 tandis que la deuxième charge d'entraînement $Q_1$ sera injectée dans le registre auxiliaire.

Au début du temps de retour ligne, la troisième charge d'entraînement $Q_2$ injectée dans le registre de lecture 3, est transférée dans la mémoire de ligne 4 en positionnant la grille C à un niveau bas, pour être utilisée comme charge d'entraînement des charges parasites $Q_B$. La charge $Q_2$ se trouve alors injectée dans la capacité $C_2$ et son utilisation comme troisième charge d'entraînement est réalisée de la même manière que lorsque la charge $Q_2$ est obtenue dans la capacité $C_2$ à partir du drain comme décrit avec référence aux figures 8(a) à 8(k).

Une fois, l'ensemble des charges $Q_2 + Q_B$ évacué dans le drain DR, la deuxième charge d'entraînement $Q_1$ est transférée du registre auxiliaire 11 vers l'étage correspondant du registre de lecture 3 en portant la barrière de potentiel sous $\emptyset_P$ à un niveau haut comme représenté sur la figure 12(b). Ensuite la barrière sous $\emptyset_P$ étant ramenée au niveau bas, la charge $Q_1$ est transférée du registre de lecture 3 vers la mémoire de ligne pour être utilisée comme charge d'entraînement des charges signal comme expliqué de manière détaillée avec référence aux figures 10(h) à 10(k). L'ensemble des charges $Q_1 + Q_S$ est alors transféré dans le registre de lecture 3 pour être acheminé vers la sortie pendant le temps ligne suivant en même temps que l'on injecte de nouvelles charges d'entraînement $Q_1$ et $Q_2$ dans les registres 3 et 11.

Dans le mode de réalisation des figures 11 à 13 on a décrit un registre auxiliaire du type transfert en surface. Toutefois le registre auxiliaire 11 peut également être du type transfert en volume, mais dans ce cas la dose d'impuretés pour la partie N doit être plus faible que celle du registre de lecture, de façon à obtenir une configuration des potentiels dans les registres 3 et 11 telle que celle représentée à la figure 12(b).

La figure 14 représente schématiquement un autre mode de réalisation permettant l'injection de la troisième charge d'entraînement $Q_2$ à l'aide d'un registre à décalage.

Conformément au mode de réalisation représenté, les deuxième et troisième charges d'entraînement $Q_1$ et $Q_2$ sont injectées directement dans le même registre à transfert de charge à savoir dans le registre de lecture. Toutefois le registre de lecture comporte un nombre d'étages qui permet de stocker successivement les deuxième et troisième quantités de charge utilisées pour un étage de mémoire ligne.

Comme représenté sur la figure 14, dans le cas d'un registre à transfert de charge fonctionnant en bi-phasé, le registre comporte un nombre d'étages double du nombre de colonnes. De ce fait le registre à transfert de charge comporte quatre électrodes de stockage pour un étage de mémoire de ligne. Dans ce cas, les deuxième et troisième charges d'entraînement $Q_1$ et $Q_2$ sont rigoureusement identiques puisqu'elles sont injectées dans un seul registre à transfert de charge.

On expliquera maintenant le fonctionnement du dispositif décrit ci-dessus.

Pendant le temps ligne, des charges Q donnant les charges $Q_1$ ou les charges $Q_2$ selon leur position sont injectées sur tout le registre à décalage. Ensuite la charge $Q_2$, à savoir la charge Q se trouvant sous l'électrode de stockage positionnée en face de la grille C, est transférée dans la mémoire de ligne pour l'évacuation des charges parasites en portant le potentiel de la grille C à un niveau haut. Il est évident que les grilles C ne sont prévues qu'entre l'électrode de stockage du registre 3 se trouvant en face de la capacité $C_2$, alors que des diffusions d'isolement sont prévues entre les autres électrodes de stockage du registre 3 et la mémoire de ligne 4.

0 115 225

Une fois l'évacuation des charges parasites vers le drain réalisée, la charge $Q_1$ est transférée deux fois dans le registre de lecture de manière à se trouver sous l'électrode de stockage en communication avec la mémoire de ligne. La charge $Q_1$ est alors transférée dans la mémoire de ligne pour effectuer la lecture de la charge signal et transférer l'ensemble des charges $Q_1 + Q_S$ dans le registre de lecture 3 comme décrit précédemment avec référence aux figures 8 ou figures 10.

Avec des registres à transfert de charge de type bi-phasé, il est nécessaire de doubler le nombre d'étages du registre pour réaliser l'injection de $Q_1$ et de $Q_2$ dans le même registre. Toutefois il est évident pour l'homme de l'art, que des registres à décalage avec un nombre de phases de commande différent peuvent être utilisés. Dans ce cas le nombre d'étages du registre de lecture n'a pas forcément besoin d'être doublé. Ainsi on peut utiliser un registre de lecture à trois phases de commande qui ne comportera que trois transferts pour un étage de mémoire ligne et qui permettra d'injecter simultanément les deuxième et troisième charges $Q_1$ et $Q_2$ dans le même registre de lecture.

La figure 15 représente encore un autre mode de réalisation d'un dispositif permettant l'injection des deuxième et troisième charges d'entraînement $Q_1$ et $Q_2$ par l'intermédiaire d'un registre à décalage.

Comme représenté sur la figure 15, le registre à décalage utilisé pour l'injection de $Q_1$ et de $Q_2$ est un registre dont les électrodes de stockage qui ne sont pas en communication avec la mémoire de ligne sont partagées en deux. Chaque partie d'électrode 17, 17' est reliée respectivement à une phase $\emptyset_1$ ou $\emptyset_1$. La coupure de l'électrode est située de préférence au milieu du canal de transfert et se trouve associée à une diffusion d'isolement 18 qui réalise ainsi un partage de la charge Q en deux parties égales $Q_1 = Q_2 = Q/2$. Il n'est pas nécessaire que le partage de la charge Q se fasse selon deux charges identiques $Q_1 = Q_2 = Q/2$ du moment que les charges $Q_1$ ou les charges $Q_2$ restent identiques avec une valeur suffisante au niveau de chaque étage de la mémoire de ligne. Les électrodes 19 en communication avec la mémoire de ligne 4 sont commandées par une phase $\emptyset_2$ et ne sont pas partagées.

On expliquera maintenant avec référence plus particulièrement à la figure 16 qui représente le potentiel appliqué sur les différentes phases $\emptyset_1$, $\emptyset'_1$, $\emptyset_2$ en fonction du temps, le fonctionnement du registre unique 3 décrit ci-dessus.

Pendant le temps ligne une charge Q est injectée en série sur chaque étage du registre. Les phases de commande $\emptyset_1$ et $\emptyset'_1$ sont alors constituées par des tensions en créneaux identiques, et la phase $\emptyset_2$ est constituée par une tension en créneaux identique mais en opposition de phase avec les phases $\emptyset_1$ et $\emptyset'_1$ de manière à réaliser le décalage de la charge Q dans tous les étages du registre. Le transfert est interrompu au début du temps de retour ligne de sorte que la charge Q se trouve sous les électrodes 17, 17'. Cette charge Q se trouve donc partagée sous la forme $Q_1 = Q_2 = Q/2$ sous chaque partie d'électrodes 17, 17'.

Au temps $t_1$, la phase $\emptyset'_1$ est portée au niveau bas ce qui transfère la charge $Q_2$ sous l'électrode 19, la phase $\emptyset_2$ étant portée au niveau haut. Ensuite, au temps $t_2$ la phase $\emptyset_2$ passe au niveau bas et la grille C de la mémoire de ligne est simultanément positionnée au niveau haut. La charge $Q_2$ est alors transférée dans la mémoire de ligne pour l'évacuation des charges parasites vers le drain.

Lors de cette opération, la phase $\emptyset_1$ passe simultanément au niveau bas pour éviter que la charge $Q_2$ ne s'écoule sous l'électrode 17 à droite de l'électrode 19.

Au temps $T_3$ la phase $\emptyset_2$ est alors portée au niveau haut.

A ce moment, la charge $Q_1$ qui se trouve sous l'électrode 17 est transférée sous l'électrode 19, puis au temps $T_4$ la phase $\emptyset_2$ revient au niveau bas et transfère la charge $Q_1$ dans la mémoire de ligne pour effectuer la lecture des charges-signal de la manière connue. L'ensemble des charges $Q_1 + Q_S$ est donc réinjecté dans le dispositif à transfert de charge 3 utilisé également comme registre de lecture, de manière à réaliser la lecture en série de la charge signal.

D'autre part, au cas où les registres à décalage utilisés pour l'injection des deuxième et troisième charges d'entraînement ne présenteraient pas une efficacité de transfert suffisante, il est possible de remédier à cet inconvénient en utilisant des registres présentant un nombre d'étages légèrement supérieur au nombre d'étages de la mémoire ligne et en éliminant ainsi les premières charges injectées dans le registre à décalage.

**Revendications**

1. Procédé d'analyse d'un dispositif photosensible à transfert de ligne, ce dispositif comportant une zone photosensible (1) de M lignes de N points photosensibles, les points photosensibles (P) des différentes lignes étant reliés en parallèle par des colonnes conductrices à une mémoire (4) qui assure le transfert vers un registre de lecture (3) des charges-signal ($Q_S$) d'une même ligne et qui assure le transfert vers un drain d'évacuation des charges-parasites ($Q_B$) se trouvant sur les colonnes avant l'arrivée des charges-signal dans lequel l'analyse de chaque ligne de la zone photosensible est réalisée en transférant les charges-signal ($Q_S$) vers la mémoire (4), en superposant aux charges-signal au moins une première charge d'entraînement ($Q_0$) stockée en mémoire et transférée sur les colonnes avant l'arrivée des charges-signal caractérisé en ce que cette première charge d'entraînement est suffisante pour permettre de passer en forte inversion au début du transfert des colonnes vers la mémoire et en ce qu'une deuxième charge d'entraînement ($Q_1$), au moins suffisante pour permettre de passer en forte inversion au début du

11

transfert, est superposée aux charges-signal ($Q_S$) lors du transfert vers le registre de lecture, cette deuxième charge d'entraînement ($Q_1$) étant lue avec les charges-signal ($Q_S$).

2. Procédé selon la revendication 1, dans lequel, pour l'évacuation des charges-parasites ($Q_B$) se trouvant sur les colonnes avant l'arrivée des charges-signal, le transfert des charges-parasites ($Q_B$) des colonnes vers la mémoire (4) est réalisé en leur superposant la même première charge d'entraînement ($Q_0$) que pour les charges-signal, le transfert ayant la même durée ($T_L$) que le transfert des charges-signal des colonnes vers la mémoire et la première charge d'entraînement ($Q_0$) étant toujours stockée en mémoire (4) et transférée périodiquement sur les colonnes, caractérisé en ce que l'on réalise le transfert des charges-parasites ($Q_B$) de la mémoire (4) vers le drain en leur superposant une troisième charge d'entraînement ($Q_2$) au moins suffisante pour permettre de passer en forte inversion au début du transfert, ce transfert ayant la même durée ($t_1$) que le transfert des charges-signal ($Q_S$) de la mémoire (4) vers le registre de lecture (3) et cette troisième charge d'entraînement étant évacuée avec les charges parasites vers le drain.

3. Procédé selon l'une des revendications 1 ou 2, caractérisé en ce que la première charge d'entraînement ($Q_0$) est importante devant la valeur maximale des charges-signal ($Q_S$max), et de l'ordre de plusieurs fois supérieure à cette valeur maximale.

4. Procédé selon l'une des revendications 1 à 3, caractérisé en ce que la deuxième charge d'entraînement ($Q_1$) est faible devant la valeur maximale des charges-signal ($Q_S$max), et de l'ordre de plusieurs fois inférieure à cette valeur maximale.

5. Procédé selon l'une des revendications 1 à 4, caractérisé en ce que la deuxième charge d'entraînement ($Q_1$) est obtenue en injectant en permanence cette quantité de charge dans le registre de lecture (3) et en la transférant dans la mémoire (4) avant l'arrivée des charges-signal ($Q_S$).

6. Procédé selon l'une des revendications 1 à 4, caractérisé en ce que la deuxième charge d'entraînement ($Q_1$) est obtenue par injection au niveau des capacités intermédiaires ($C_1$) que comporte la mémoire (4).

7. Procédé selon l'une quelconque des revendications 1 à 4, caractérisé en ce que la deuxième charge d'entraînement ($Q_1$) est obtenue en éclairant par un éclairement uniforme la zone photosensible (1) de manière à générer en permanence une charge qui se superpose à la charge-signal.

8. Procédé selon la revendication 7 caractérisé en ce que, dans le cas d'une zone photosensible recouverte de filtres colorés, l'éclairement en pluie est réalisé dans une longueur d'onde telle que la transmission des filtres colorés soit équivalente quel que soit le filtre.

9. Procédé selon l'une des revendications 1 à 7, caractérisé en ce que la troisième charge d'entraînement ($Q_2$) est introduite dans la mémoire (4) à partir du drain d'évacuation.

10. Procédé selon l'une quelconque des revendications 1 à 7, caractérisé en ce que la troisième charge d'entraînement ($Q_2$) est obtenue en injectant en série pendant le temps ligne cette quantité de charge dans un registre à décalage à transfert de charge (3, 10, 11) à entrée série et sorties parallèles positionné parallèlement à la mémoire de ligne et en la transférant du registre vers la mémoire de ligne (4).

11. Procédé selon la revendication 10 caractérisé en ce que le registre à décalage à transfert de charge (10) est positionné à l'extrémité des colonnes de la zone photosensible (1) du côté opposé à la mémoire de ligne (4), le transfert de la charge vers la mémoire de ligne étant réalisé par l'intermédiaire des colonnes.

12. Procédé selon la revendication 10 caractérisé en ce que le registre à décalage à transfert de charge (11) est adjacent au registre de lecture (3) constitué par un registre du type à transfert en volume, les deux registres (3, 11) étant commandés par des phases de commande ($\emptyset_1$, $\emptyset_2$) identiques et communiquant au niveau d'une des phases ($\emptyset_1$) par l'intermédiaire d'une grille de passage ($\emptyset_P$), la troisième charge d'entraînement ($Q_2$) étant injectée dans le registre de lecture (3) et la deuxième charge d'entraînement ($Q_1$) dans le registre à décalage (11).

13. Procédé selon la revendication 12 caractérisé en ce que le registre à décalage (11) est du type à transfert en volume avec une dose d'implantation d'impuretés plus faible que celle du registre de lecture (3).

14. Procédé selon l'une quelconque des revendications 12 et 13 caractérisé en ce que les deuxième et troisième charges d'entraînement ($Q_1$, $Q_2$) sont obtenues par séparation d'une charge unique ($Q_e$) injectée dans un étage d'entrée commun au registre à décalage (11) et au registre de lecture (3).

15. Procédé selon l'une quelconque des revendications 12 et 13 caractérisé en ce que les deuxième et troisième charges d'entraînement ($Q_1$, $Q_2$) sont injectées séparément par des étages d'entrée différents (14, 15) dans le registre à décalage (11) et dans le registre de lecture (3).

16. Procédé selon l'une quelconque des revendications 1 et 4, caractérisé en ce que les deuxième et troisième charges d'entraînement ($Q_1$, $Q_2$) sont obtenues en injectant en série pendant le temps ligne une quantité de charges dans le registre de lecture (3) qui comporte un nombre d'étages permettant de stocker successivement pour un étage de mémoire ligne (4), deux quantités de charge identiques correspondant aux deuxième et troisième charges d'entraînement.

17. Procédé selon l'une quelconque des revendications 1 à 4 caractérisé en ce que les deuxième et troisième charges d'entraînement sont obtenues en injectant en série, pendant le temps ligne, une quantité de charge (Q) dans le registre de lecture (3) constitué par un registre à décalage série-parallèle

12

comportant au moins deux électrodes de stockage pour un étage de mémoire ligne, une des électrodes de stockage ne communiquant pas avec la mémoire ligne étant constituée par deux parties d'électrodes (17, 17') de manière à séparer la charge injectée (Q) en deux charges ($Q_1 = Q_2 = Q/2$), les phases de commande ($\emptyset$, $\emptyset_1$, $\emptyset_2$) appliquées sur les différentes électrodes (17, 17', 18) étant choisies de manière à pouvoir transférer séparément les deux charges ($Q_1$, $Q_2$) vers la mémoire de ligne.

18. Procédé selon l'une quelconque des revendications 10, 16 et 17 caractérisé en ce que les deuxième et troisième charges d'entraînement ($Q_1$, $Q_2$) sont injectées dans des registres à décalage à transfert de charge (3, 10, 11) comportant un nombre d'étages supérieur au nombre d'étages de la mémoire de ligne.

19. Dispositif de mise en œuvre d'un procédé selon l'une des revendications 1 à 18, caractérisé en ce que la mémoire de ligne (4) comporte une série de capacités intermédiaires ($C_1$) chaque capacité étant reliée d'une part à une colonne et d'autre part à des moyens de communication conduisant le contenu des capacités intermédiaires soit vers le drain d'évacuation, soit vers le registre de lecture (3).

20. Dispositif selon la revendication 19, caractérisé en ce que la mémoire de ligne (4) est une mémoire à double étage dont les moyens de commutation sont constitués par une série de capacité ($C_2$), l'accès à chaque capacité étant commandé par trois grilles, une grille ($G_0$) qui permet l'arrivée des charges en provenance des capacités intermédiaires et qui retient la première charge d'entraînement ($Q_0$) et deux grilles (R et C) qui permettent le transfert des charges vers le drain ou vers le registre de lecture.

## Claims

1. A method for analysing a photosensitive device of the line transfer type, this device comprising a photosensitive zone (1) with M lines having each N photosensitive points, the photosensitive points (P) of the different lines being connected in parallel via column conductors to a memory (4) which ensures the transfer of the signal charges ($Q_S$) of one line to a read-out register (3) and which ensures the transfer of the parasitic charges ($Q_B$) which are present on the column conductors prior to the arrival of the signal charges, to an evacuation drain, the method according to which the analysis of each line of the photosensitive zone is realized by transferring the signal charges ($Q_S$) to the memory (4) and by superposing to the signal charges at least a first driver charge ($Q_0$) stored in memory and transferred onto the column conductors prior to the arrival of the signal charges, characterized in that said first driver charge is strong enough to allow a passage to a strong inversion at the beginning of the transfer from the column conductors to the memory, and that a second driver charge ($Q_1$) which is at least strong enough to allow the passage to a strong inversion at the beginning of the transfer, is superposed to the charge signal ($Q_S$) during the transfer towards the read-out register, this second driver charge ($Q_1$) being read together with the signal charges ($Q_S$).

2. A method according to claim 1, in which for the evacuation of the parasitic charges ($Q_B$) present on the column conductors prior to the arrival of the signal charges, the transfer of the parasitic charges ($Q_B$) from the columns towards the memory (4) is realized by superposing thereto the same first driver charge ($Q_0$) as for the signal charges, the transfer having the same duration ($T_L$) as the transfer of the signal charges from the column conductors to the memory, and the first driver charge ($Q_0$) being always stored in memory (4) and periodically transferred to the column conductors, characterized in that the transfer of the parasitic charges ($Q_B$) from the memory (4) to the drain is realized by superposing thereto a third driver charge ($Q_2$) which is at least strong enough to allow the passage to strong inversion at the beginning of the transfer, this transfer having the same duration ($t_1$) as the transfer of the signal charges ($Q_S$) from the memory (4) towards the read-out register (3), that third driver charge being evacuated together with the parasitic charges towards the drain.

3. A method according to one of claims 1 or 2, characterized in that the first driver charge ($Q_0$) is important compared with the maximum value of the signal charges ($Q_S$max) and of a magnitude which is several times higher than that maximum value.

4. A method according to one of claims 1 to 3, characterized in that the second driver charge ($Q_1$) is small compared with the maximum value of the signal charges ($Q_S$max) and is of a magnitude several times smaller than that maximum value.

5. A method according to one of claims 1 to 4, characterized in that the second driver charge ($Q_1$) is obtained by permanently injecting this charge quantity into the read-out register (3) and by transferring it into the memory (4) prior to the arrival of the signal charges ($Q_S$).

6. A method according to one of claims 1 to 4, characterized in that the second driver charge ($Q_1$) is obtained by an injection at the level of the intermediate capacities ($C_1$) included in the memory (4).

7. A method according to any one of claims 1 to 4, characterized in that the second driver charge ($Q_1$) is obtained by illuminating uniformly the photosensitive zones (1) such that there is permanently created a charge which is superposed to the signal charge.

8. A method according to claim 7, characterized in that in the case of a photosensitive zone covered by coloured filters, the rain illumination is realized at such a wavelength that the transmission rate of the coloured filters is equivalent from one filter to the other.

9. A method according to one of claims 1 to 7, characterized in that the third driver charge ($Q_2$) is introduced into the memory (4) via the evacuation drain.

10. A method according to any one of claims 1 to 7, characterized in that the third driver charge ($Q_2$) is obtained by injecting this charge quantity in series during the line period into a charge transfer shift register (3, 10, 11) having a series input and parallel outputs and being positioned parallely to the line memory, and transferring this charge from the register to the line memory (4).

11. A method according to claim 10, characterized in that the charge transfer shift register (10) is located at the opposite end of the column conductors of the photosensitive zone (1) with respect to the line memory (4), the charge transfer to the line memory being made via the column conductors.

12. A method according to claim 10, characterized in that the charge transfer shift register (11) is adjacent to the read-out register (3) constituted by a volume transfer register, the two registers (3, 11) being controlled by identical control phases ($\emptyset_1$, $\emptyset_2$) and communicating at the level of one of these phases ($\emptyset_1$) via a passage grid ($\emptyset_P$), the third driver charge ($Q_2$) being injected into the read-out register (3) and the second driver charge ($Q_1$) being injected into the shift register (11).

13. A method according to claim 12, characterized in that the shift register (11) is of the volume transfer type, its impurity implantation rate being lower than that of the read-out register (3).

14. A method according to any one of claims 12 and 13, characterized in that the second and third driver charges ($Q_1$, $Q_2$) are obtained by separating a common charge ($Q_e$) injected into an input stage which is common to the shift register (11) and to the read-out register (3).

15. A method according to any one of claims 12 and 13, characterized in that the second and third driver charges ($Q_1$, $Q_2$) are separately injected through different input stages (14, 15) into the shift register (11) and into the read-out register (3).

16. A method according to any one of claims 1 to 4, characterized in that the second and third driver charges ($Q_1$, $Q_2$) are obtained by injecting a quantity of charges in series during the line period into the read-out register (3) which comprises such a number of stages allowing to store successively for one stage of the line memory (4) two identical quantities of charge corresponding to the second and third driver charges.

17. A method according to any one of claims 1 to 4, characterized in that the second and third driver charges are obtained by injecting a quantity of charge (Q) in series during the line period into the read-out register (3) constituted by a series parallel shift register comprising at least two memory electrodes for one line memory stage, one of the memory electrodes which does not communicate with the line memory being constituted by two electrode portions (17, 17') in such a way that the injected charge (Q) is separated into two charges ($Q_1 = Q_2 = Q/2$), the control phases ($\emptyset$, $\emptyset_1$, $\emptyset_2$) applied to the different electrodes (17, 17', 18) being chosen to be able to transfer separately the two charges ($Q_1$, $Q_2$) towards the line memory.

18. A method according to any one of claims 10, 16 and 17, characterized in that the second and third driver charges ($Q_1$, $Q_2$) are injected into charge transfer shift registers (3, 10, 11) comprising a number of stages which is higher than the number of stages of the line memory.

19. A device for implementing a method according to one of claims 1 to 18, characterized in that the line memory (4) comprises a series of intermediate capacities ($C_1$), each capacity being connected on the one hand to a column conductor and on the other hand to switch means transmitting the contents of the intermediate capacities either towards the evacuation drain or towards the read-out register (3).

20. A device according to claim 19, characterized in that the line memory (4) is a double stage memory in which the switch means are constituted by a series of capacities ($C_2$), the access to each capacity being controlled by three grids, a first grid ($G_0$) allowing the charges to arrive from the intermediate capacities and retaining the first driver charge ($Q_0$), and two further grids (R and C) allowing the transfer of the charges towards the drain or towards the read-out register.


**Patentansprüche**

1. Verfahren zur Analyse einer lichtempfindlichen Vorrichtung vom Zeilentransfertyp, mit einer aus M Zeilen von je N lichtempfindlichen Punkten bestehenden lichtempfindlichen Zone (1), wobei die lichtempfindlichen Punkte (P) der verschiedenen Zeilen parallel über Spaltenleiter an einen Speicher (4) angeschlossen sind, der den Transfer der Signalladungen ($Q_S$) einer ganzen Zeile an ein Leseregister (3) sowie den Transfer der Störladungen ($Q_B$) bewirkt, die sich auf den Spaltenleitern vor dem Eintreffen der Signalladungen an einen Ableitungspol befinden, wobei die Analyse jeder Zeile der lichtempfindlichen Zone durch Übertragung der Signalladungen ($Q_S$) in den Speicher (4) und durch Überlagerung der Signalladungen mit mindestens einer ersten Treibladung ($Q_0$) bewirkt wird, die von einem Speicher vor dem Eintreffen der Signalladungen auf die Spaltenleiter übertragen wird, dadurch gekennzeichnet, daß die erste Treibladung ausreicht, um zu Beginn des Transfers von den Spalten in den Speicher in kräftige Inversion zu gelangen, und daß eine zweite Treibladung ($Q_1$), die zumindest ausreicht, um zu Beginn des Transfers in heftige Inversion zu gelangen, den Signalladungen ($Q_S$) während des Transfers in das Leseregister überlagert wird, wobei diese zweite Treibladung ($Q_1$) zusammen mit den Signalladungen ($Q_S$) gelesen wird.

**0 115 225**

2. Verfahren nach Anspruch 1, in dem zur Ableitung der Störladungen ($Q_B$), die sich auf den Spaltenleitern vor dem Eintreffen der Signalladungen befinden, der Transfer der Störladungen ($Q_B$) von den Spaltenleitern zum Speicher (4) so erfolgt, daß ihnen die gleiche erste Treibladung ($Q_0$) überlagert wird wie den Signalladungen, wobei der Transfer dieselbe Dauer ($T_L$) wie der Transfer der Signalladungen von den Spaltenleitern auf den Speicher besitzt und die erste Treibladung ($Q_0$) stets im Speicher (4) gespeichert und periodisch auf die Spalten übertragen wird, dadurch gekennzeichnet, daß der Transfer der Störladungen ($Q_B$) vom Speicher (4) zum Ableitungspol durch Überlagerung mit einer dritten Treibladung ($Q_2$) bewirkt wird, die mindestens ausreicht, um zu Beginn des Transfers in heftige Inversion zu gelangen, wobei dieser Transfer dieselbe Dauer ($t_1$) wie der Transfer der Signalladungen ($Q_S$) vom Speicher (4) zum Leseregister (3) besitzt und diese dritte Treibladung zusammen mit den Störladungen zum Ableitpol abgeführt wird.

3. Verfahren nach einem der Ansprüche 1 oder 2, dadurch gekennzeichnet, daß die erste Treibladung ($Q_0$) sehr groß im Verhältnis zum Höchstwert der Signalladungen ($Q_S$max) ist, d. h. in der Größenordnung eines Mehrfachen dieses Maximalwerts.

4. Verfahren nach einem der Ansprüche 1 bis 3, dadurch gekennzeichnet, daß die zweite Treibladung ($Q_1$) einen geringen Wert bezüglich des Maximalwerts der Signalladungen ($Q_S$max) besitzt, d. h. in der Größenordnung eines kleinen Bruchteils dieses Maximalwerts.

5. Verfahren nach einem der Ansprüche 1 bis 4, dadurch gekennzeichnet, daß die zweite Treibladung ($Q_1$) durch dauernde Injektion dieser Ladungsmenge in das Leseregister (3) und durch deren übertragung in den Speicher (4) vor dem Eintreffen der Signalladungen ($Q_S$) erhalten wird.

6. Verfahren nach einem der Ansprüche 1 bis 4, dadurch gekennzeichnet, daß die zweite Treibladung ($Q_1$) durch Injektion in Höhe der im Speicher (4) enthaltenen Zwischenkondensatoren ($C_1$) erreicht wird.

7. Verfahren nach einem beliebigen der Ansprüche 1 bis 4, dadurch gekennzeichnet, daß dei zweite Treibladung ($Q_1$) durch gleichmäßige Beleuchtung der lichtempfindlichen Zone (1) erhalten wird, so daß dauernd eine Ladung erzeugt wird, die sich der Signalladung überlagert.

8. Verfahren nach Anspruch 7, dadurch gekennzeichnet, daß die Beleuchtung bei Regen im Fall einer lichtempfindlichen Zone, die von Farbfiltern bedeckt ist, mit einer solchen Wellenlänge erfolgt, daß die Durchlässigkeit der Farbfilter unabhängig vom Filter äquivalent ist.

9. Verfahren nach einem Ansprüche 1 bis 7, dadurch gekennzeichnet, daß die dritte Treibladung ($Q_2$) in den Speicher (4) vom Ableitpol aus eingebracht wird.

10. Verfahren nach einem beliebigen der Ansprüche 1 bis 7, dadurch gekennzeichnet, daß die dritte Treibladung ($Q_2$) durch Injektion dieser Ladungsmenge in Reihe während der Zeilenzeit in ein Ladungstransferschieberegister (3, 10, 11) erhalten wird, das einen Reiheneingang und parallele Ausgänge besitzt und parallel zum Zeilenspeicher angeordnet ist sowie die dritte Treibladung vom Register an den Zeilenspeicher (4) überträgt.

11. Verfahren nach Anspruch 10, dadurch gekennzeichnet, daß das Ladungstransferschieberegister (10) am Ende der Spalten der lichtempfindlichen Zone (1) auf der gegenüberliegenden Seite bezügliche des Zeilenspeichers (4) angeordnet ist, wobei der Ladungstransfer zum Zeilenspeicher über die Spaltenleiter erfolgt.

12. Verfahren nach Anspruch 10, dadurch gekennzeichnet, daß das Ladungstransferschieberegister (11) neben dem als Register vom Volumentransfertyp ausgebildeten Leseregister (3) liegt, wobei die beiden Register (3, 11) von gleichen Steuerphasen ($\emptyset_1$, $\emptyset_2$) gesteuert werden und in Höhe einer der Phasen ($\emptyset_1$) über ein Durchlaßgitter ($\emptyset_P$) miteinander in Verbindung stehen, und wobei die dritte Treibladung ($Q_2$) in das Leseregister (3) und die zweite Treibladung ($Q_1$) in das Schieberegister (11) injiziert wird.

13. Verfahren nach Anspruch 12, dadurch gekennzeichnet, daß das Schieberegister (11) vom Volumentransfertyp ist und eine geringere Rate an implantierten Fehlstellen als das Leseregister (3) besitzt.

14. Verfahren nach einem beliebigen der Ansprüche 12 und 13, dadurch gekennzeichnet, daß die zweite Treibladung ($Q_1$) und die dritte Treibladung ($Q_2$) durch Trennung einer einzigen in eine dem Schieberegister (11) und dem Leseregister (3) gemeinsame Eingangsstufe injizierte Ladung ($Q_e$) erhalten werden.

15. Verfahren nach einem beliebigen der Ansprüche 12 und 13, dadurch gekennzeichnet, daß die zweite Treibladung ($Q_1$) und die dritte Treibladung ($Q_2$) getrennt durch unterschiedliche Eingangsstufen (14, 15) in das Schieberegister (11) und das Leseregister (3) injiziert werden.

16. Verfahren nach einem beliebigen der Ansprüche 1 bis 4, dadurch gekennzeichnet, daß die zweite Treibladung ($Q_1$) und die dritte Treibladung ($Q_2$) durch Injektion einer Ladungsmenge in Reihe während der Zeilenzeit in das Leseregister (3) erhalten werden, das eine solche Anzahl von Stufen aufweist, um nacheinander für eine Stufe des Zeilenspeichers (4) zwei identische Ladungsmengen entsprechend der zweiten und der dritten Treibladung speichern zu können.

17. Verfahren nach einem beliebigen der Ansprüche 1 bis 4, dadurch gekennzeichnet, daß die zweite Treibladung und die dritte Treibladung durch Injektion einer Ladungsmenge ($Q$) in Reihe während der Zeilenzeit in das Leseregister (3) erhalten werden, das von einem Serien-Parallel Schieberegister gebildet wird und mindestens zwei Speicherelektroden für eine Stufe des Zeilenspeichers besitzt, wobei eine der Speicherelektroden, die nicht mit dem Zeilenspeicher in Verbindung steht, von zwei Elektrodenbereichen (17, 17') gebildet wird, so daß die injizierte Ladung (Q) in zwei Ladungen ($Q_1 = Q_2 = Q/2$) aufgeteilt wird und die an die verschiedenen Elektroden (17, 17', 18) angelegten Steuerphasen ($\emptyset$, $\emptyset_1$, $\emptyset_2$) so gewählt werden, daß die beiden Ladungen ($Q_1$, $Q_2$) getrennt an den Zeilenspeicher übertragen werden können.

18. Verfahren nach einem beliebigen der Ansprüche 10, 16 und 17, dadurch gekennzeichnet, daß die zweite Treibladung ($Q_1$) und die dritte Treibladung ($Q_2$) in Ladungstransferschieberegister (3, 10, 11) injiziert werden, deren Anzahl von Stufen größer als die Anzahl von Stufen des Zeilenspeichers ist.

19. Vorrichtung zur Durchführung eines Verfahrens nach einem der Ansprüche 1 bis 18, dadurch gekennzeichnet, daß der Zeilenspeicher (4) eine Reihe von Zwischenkondensatoren ($C_1$) besitzt, die je einerseits an einen Spaltenleiter und andererseits an Schaltmittel angeschlossen sind, die den Inhalt der Zwischenkondensatoren entweder an den Ableitungspol oder an das Leseregister (3) weiterleiten.

20. Vorrichtung nach Anspruch 19, dadurch gekennzeichnet, daß der Zeilenspeicher (4) ein Speicher mit zwei Stufen ist, dessen Schaltmittel aus einer Reihe von Kondensatoren ($C_2$) bestehen, wobei der Zugang zu jedem Kondensator durch drei Gitter gesteuert wird, nämlich einem ersten Gitter ($G_0$), das das Eintreffen der Ladungen von den Zwischenkondensatoren erlaubt und die erste Treibladung zurückbehält, und zwei weiteren Gitter (R und C), die die Übertragung der Ladungen zum Ableitungspol oder zum Leseregister zulassen.

**0 115 225**

FIG_1

COLONNES

REGISTRE D'ADRESSAGE

2

1

P₂

$q_0+q_s$ $q_0+q_s$ $q_0+q_s$ $q_0+q_s$

$q_0$ $q_0$ $q_0$ $q_0$

INJECTION DE $q_0$

REGISTRE DE LECTURE

3 $q_0+q_s$

FIG_2

COLONNES

REGISTRE D'ADRESSAGE

2

1

$q_0$ $q_0+q_s$ $q_0$ $q_0+q_s$

4 $c_i$

DRAIN

$q_s$ $q_s$ $q_s$ $q_s$

3 REGISTRE DE LECTURE

# FIG_3

# FIG_4

# FIG_5

forte inversion | faible inversion

# FIG_6

# FIG_7

# FIG. 8

FiG_9

# FIG_10

## FIG_11

## FIG_12-a

## FIG_12-b

## FIG_14

## FIG_15

## FIG_16

## FIG_13